(19) Europäisches Patentamt / European Patent Office / Office européen des brevets

(11) **EP 3 987 457 B1**

(12) **EUROPEAN PATENT SPECIFICATION**

(45) Date of publication and mention
of the grant of the patent:
**10.01.2024 Bulletin 2024/02**

(21) Application number: **20732977.2**

(22) Date of filing: **19.06.2020**

(51) International Patent Classification (IPC):
**G06N 10/20** *(2022.01)*   **G06N 10/40** *(2022.01)*
**G06N 10/70** *(2022.01)*

(52) Cooperative Patent Classification (CPC):
**G06N 10/40; G06N 10/20; G06N 10/70**

(86) International application number:
**PCT/EP2020/067169**

(87) International publication number:
**WO 2020/254620 (24.12.2020 Gazette 2020/52)**

(54) **TOPOLOGICAL QUANTUM ERROR CORRECTION USING A DATA BUS**

TOPOLOGISCHE QUANTENFEHLERKORREKTUR MIT EINEM DATENBUS

CORRECTION D'ERREUR QUANTIQUE TOPOLOGIQUE AU MOYEN D'UN BUS DE DONNÉES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.06.2019 EP 19181735**

(43) Date of publication of application:
**27.04.2022 Bulletin 2022/17**

(73) Proprietor: **Second Foundation Inc. SF
Cambridge MA 02138 (US)**

(72) Inventors:
• **DEVITT, Simon
Waterloo, New South Wales 2017 (AU)**
• **REILLY, Michele
1190 Wien (AT)**

(74) Representative: **Scharfenberger, Burkhard
Pöhner Scharfenberger
Inh. Patentanwalt Dr. Burkhard Scharfenberger
Kaiserstraße 33
97070 Würzburg (DE)**

(56) References cited:
• **Daniel Herr ET AL: "Time versus Hardware:
Reducing Qubit Counts with a (Surface Code)
Data Bus", , 1 April 2019 (2019-04-01), pages 1-24,
XP055653496, arXiv.org Retrieved from the
Internet:
URL:https://arxiv.org/pdf/1902.08117.pdf
[retrieved on 2019-12-17]**

EP 3 987 457 B1

## Description

FIELD

Embodiments of the present disclosure relate to methods and devices for performing fault-tolerant and error corrected quantum computing, in particular, topological quantum computing based on the planar- or surface-code.

BACKGROUND

Quantum computing involves operations on qubits, which, unlike conventional bits that can only be either in the state '0' or '1', may be in any quantum mechanical superposition of these two states. By thus allowing to effectively operate on a large number of inputs simultaneously, certain quantum algorithms, most notably Shor's Algorithm for factoring large numbers, achieve an up to exponentially large speedup over classical algorithms.

However, due to the non-discrete nature of the information represented by a qubit, it is much more susceptible to errors than a classical bit. Therefore useful implementations of quantum algorithms on physical quantum computing devices are reliant on error correction, where a *logical* qubit is encoded into two distinct sub-spaces of the joint Hilbert space of several *physical* qubits. Since current quantum computing devices contain still a comparatively small number of qubits, they do not have the required capacity to implement useful algorithms with a sufficient degree of fault tolerant error-correction.

One promising paradigm for achieving general quantum computation is Topological Quantum Error Correction. Schemes according to this paradigm store single logical qubits in a lattice of physical qubits in a topologically non-trivial joint quantum state, and use quantum measurement and purely classical error correction to preserve the logical qubits in the face of experimental conditions. This permits logical qubits to be preserved for substantially longer than the typical coherence time of the physical qubits.

In Topological Quantum Error Correction, operations on logical qubits are implemented by topologically non-trivial operations on the underlying physical qubits. Since errors are mostly caused by local processes, i.e. processes affecting only one or a small number of physical qubits but not the majority or all of them at once, error protection in Topological Quantum Error Correction schemes arises from the properties of the topological states used to encode the logical qubits. These topological states can only be affected by global changes but not by merely local ones.

One implementation of topological quantum error correction is based on surface codes, which evolved from an idea by Alexei Kitaev known as toric codes. The latter were invented as simple models for topologically ordered quantum states and comprised qubits distributed on the surface of a toroid. The toroidal geometry/topology turned out to be unnecessary and planar versions, the planar or surface codes, also showing topologically non-trivial behavior were developed by Kitaev and others.

In the surface code, logical qubits are represented by square patches of $(d+1)\times(d+1)$ qubits, with d called the distance of the surface code. A part of these qubits are classified as data qubits and the rest as syndrome qubits, each class arranged in a square lattice forming a sub-lattice of the square patch. The qubits of the patch are prepared in a topologically non-trivial joint quantum state and kept corrected against errors by stabilizer measurements on the syndrome qubits, where a stabilizer corresponds to a product operator on the joint Hilbert space of all the syndrome qubits in a patch.

The parameter *d* is the distance of that implementation of the surface code and is a measure for the level of error correction. If more protection from errors is required or desired, one may simply increase the distance *d* of the code, i.e. the size of the surface code patches. This obviates the need for nested error correction, where the qubits used in forming a logical qubit are themselves logical qubits. This is in principle also possible for the surface code, but is more cumbersome and less efficient than simply increasing the distance of the code. Therefore, when in the following reference is made to the qubits of a surface code patch this should be understood to refer to *physical* qubits, unless otherwise stated.

When compared to standard, non-topological error corrected quantum computing schemes, the theoretical error thresholds, i.e. the maximum permissible probability of an error occurring in a physical qubit such that error correction leads to a reduction in the error probability of the logical qubits, of topological quantum error correction schemes are significantly higher, for instance around 1 % in case of the surface codes.

However, a downside of Topological Quantum Error Correction is the large overhead in logical ancilla qubits, usually prepared in some special quantum state, required to perform both single and multi-qubit operations. Thus, while compared to non-topological schemes employing nested layers of error correction, much fewer physical qubits are required per top-level logical qubit to achieve a certain desired level of error per (top-level) logical qubit, this need for ancilla qubits drives up the number of both physical qubits required and also creates an operational overhead in having to continually prepare a, potentially large, number of ancilla qubits in a certain quantum state.

To allow useful quantum computation as early as possible, algorithms need to be optimized such that less logical qubits are required. Fault tolerant computation protocols need to be optimized such that the overhead of physical qubits is reduced.

Such an optimization for the surface code as the underlying error correction protocol and lattice surgery as a means of computation was put forward in a recent proposal by Daniel Litinski in "A game of surface codes: Large-scale quantum computing with lattice surgery". It reduces the overhead in time and physical qubits by moving to lattice surgery based methods of computation. In particular, it achieves an order of magnitude improvement in the number of physical qubits required to enact a certain set of logic gates over braid-based techniques with the introduction of multi-qubit measurements.

A remaining disadvantage is however, that the measurements used in this proposal require all-to-all connectivity between logical qubits and therefore patches of logical ancilla qubits need to be introduced for their protocol, leading to a spatial overhead of additional physical qubits, that are not strictly a part of the error-corrected computation.

In "Time versus Hardware: Reducing Qubit Counts with a (Surface Code) Data Bus" (https://arxiv.org/pdf/1902.08117.pdf) Daniel Herr et al. propose to reduce the overhead in ancilla qubits needed in lattice surgery by introducing a data-bus consisting of a chain of $N$ logical qubits prepared in a GHZ state, where the length $N$ is sufficient to connect the two surface code patches between which a two-qubit operation is to be performed along the whole length of one of their sides not facing each other, i.e. in their scheme $N$ is at least 2d+1 and equal to that value in case of neighboring surface patches.

The scheme is presented to be fault tolerant in that is able to detect ($d$-1) Div 2 and correct up to at most (d-2) Div 2, where "Div" denotes the integer devision errors on the $N$ data bus qubits. As usual, a fault tolerance against (up to) $k$ errors entails that the highest order error terms appearing in an error channel analysis of a quantum circuit are of order $p^{k+1}$.

However, for non-trivial reasons, the scheme presented there turns out not to be fully fault tolerant since, as was first understood by the inventors of present invention, it cannot deal with pre-existing errors on the (physical) data qubits of the logical qubits to be connected and interacted by the data bus. Such errors get copied to the data bus qubits upon the latter's establishment and corrupt the parity check operation of the N qubit chain, thereby causing a logical error in the computation. This cannot be dealt with by the simple repetition of the data bus proposed in the aforementioned prior art, since the same errors will be copied to the data bus qubits on every repetition.

SUMMARY

It is therefore an object of the present invention to find a quantum computing device and a method for performing quantum computing, that achieves the connectivity between qubits necessary for performing lattice surgery with a smaller number of logical ancilla qubits, thereby reducing the spatial overhead in qubits and reducing the time required for a single interaction, while retaining some measure of full fault-tolerance.

In a first aspect of the invention, this object is achieved in a device for performing quantum computing according to claim 1.

As set out in the claim, the device comprises a first square patch of (d+1)×(d+1) qubits and a second square patch of (d+1)×(d+1) qubits, both in a joint quantum state corresponding to a planar or surface code with distance d>=2, in the following also referred to as the first and second surface code patch respectively, wherein each patch encodes a logical qubit. The first and second surface code patch are connected by a patch of N × w physical qubits in a joint quantum state serving as a data bus. The connection is made possible in that n1 qubits of the data bus patch are each adjacent to a qubit of the first surface code patch and n2 qubits of the chain are each adjacent to a qubit of the second surface code patch, where 0<n1, n2 < N. The sum of n1 and n2 has to be smaller or equal to the length $N$ and the width w of the data bus qubit patch, or simply data bus, has to be at least one qubit, i.e. w>=1, but is less than the 'width' of a surface code patch, i.e. w =< $d$.

In order to correct against logical bit and phase flip errors, according to the invention, the device is configured to perform h-cycles of error correction for all data bus qubits where $d >= h >= 1$. The repeated cycles are to "catch" any errors that may change syndrome measurement results. These could be errors on the actual qubits measured to obtain the syndrome or they could be errors that have propagated through circuits and consequently anti-commute with the measurement being performed. Measurement errors on the syndromes need to be corrected otherwise when the split and merge operations are performed between the logical qubits and the bus, parity information is incorrect which in turn induces logical bit and/or phase flips on the encoded qubits.

Moreover, as physical measurements during the bus operation cause parity information of all the measurements on the bus to change (i.e. a single, uncorrected physical measurement can flip a global parity of all the measurement). Since the global parity of all the measurements is what determines the final logical state of the qubits after the bus operations, an incorrect parity in effect induces a logical error. Therefore, according to the invention, in order to achieve fault tolerance, it also needs to correct errors introduced by the final, unprotected parity measurement of the data bus. The device is configured to repeat the interaction between the logical qubits mediated by the data bus a number of times r, with r >= 1, where r = 1 means the data bus is established only once. This ensures a redundancy which enables suppressing errors not corrected for by the h cycles of error correction performed during the time a single data bus is active, in particular errors in the joint parity measurements of the first and second logical qubit.

In the context of present invention, fault-tolerance is synonymous with fully suppressing all errors in the data bus and the interaction mediated by it, i.e. both suppressing both logical bit flip and phase flip errors in all involved qubits, up to a desired level k.

The amount of redundancy, and hence the number of repetitions r of the data bus mediated interaction the device of the invention is configured to perform, is determined by the desired level k of fault tolerance. This level determines the total space-time volume $V_{DB}$ of the data bus including its repetitions, which is given by $V_{DB} = w \times h \times r$.

In some embodiments, the level of desired fault tolerance k is chosen to be equal to the maximum level of fault tolerance for the logical qubits implemented as square planar code patches of distance d, i.e. $k = k_{max}$ = $d$-2 Div 2. In these embodiments, in order to achieve the desired goal of full fault tolerance, the parameters w, h, and r need to satisfy the relationship $w \times h \times r \geq d^2$.

In other embodiments, where $k$ is chosen smaller than $k_{max}$, those three parameters must still satisfy $w \times h \times r > 4k^2$. For instance, in some embodiments, $k$ may be chosen equal to d-4 Div 2. In these embodiments it holds for $w, h$ and rthat $\times h \times r > (d - 4)^2$

In some embodiments of the invention, the number of repetitions r is chosen larger than one, $r>1$, for instance r=2, 3, ...,d-1, d. I.e., for embodiments of the device of the invention with a surface code depth of $d$=4, the number of repetitions may be chosen to be $r$ =1, 2, 3 or 4.

Similarly, the width w and height $h$ of the data bus are not fixed at a single (integer) value, but can be traded of against each other, as well as the number of repetitions $r$, so long as the total space-time volume of the data bus satisfies the above requirements given the desired level $k$ of fault tolerance.

Thus, the width of the data bus may in some embodiments of the invention be equal to $w$ = 1, 2, 3, ..., $d$-1 or $d$. Again using embodiments with d=4 as example, this means the data bus width may then be chosen to be $w$ = 1, 2, 3 or 4.

Analogously the number of error correction cycles $h$ run on the data bus qubits may be any integer value between 1 and d, i.e. $h$ = 1, 2, ... $d$-1 or d, for instance, in embodiments with $d$=4, $h$ = 1, 2, 3 or 4.

The parameter combination $w = h = d$ corresponds to the known lattice surgery technique with its above described drawbacks and is thus, irrespective of any possible repetitions, not in the scope of the invention.

However, in some preferred embodiments the width w of the data bus is chosen to be equal to or larger than three, i.e. $w>= 3$, e.g., if $d$ = 4, then w = 3 or 4 , as only a width of three or more ensures, that sufficient information is available in the data bus in order to correct pre-existing errors of the physical data qubits of the two or more logical qubits to be interacted via the data bus without the need for computing complicated space-time cross correlations between physical qubits of the data bus and those of the logical qubits.

In embodiments of the quantum computing device of the invention, where qubits are arranged in a square lattice, "adjacent" refers to pairs of nearest neighbor qubits.

In some embodiments three or more logical qubits in the form of surface code patches are used. All surface code patches are effectively connected through one or more data buses. In some embodiments there is only a single qubit patch serving as a data bus. In other embodiments there is more than one qubit patch serving as data bus. The data bus patches may be of the same or different lengths and of the same or different width.

Similar to the logical qubits to be interacted, the joint quantum state qubits of the data bus may be a topological quantum state such as a surface code state. There may be a distinction between data qubits and syndrome qubits and the joint quantum state of the data bus qubits is error corrected in a similar way as that of the surface code patches encoding the logical qubits of the device, i.e. by (repeated) stabilizer measurement of the syndrome qubits.

A data bus connects two surface code patches if for each patch there is at least one qubit in the data bus adjacent to it. In some embodiments the patch of qubits serving as data bus connects only two of the surface code patches of the quantum computing device. In other embodiments it connects more than two, in particular all of the surface code patches.

In some embodiments, there is a chain of qubits serving as data bus, i.e. a patch of qubits with a width of w = 1.

In some embodimens the width is chosen w = 3, which is the minimum required to ensure a physical nearest neighbour connectivity between physical qubits of the data bus can be achieved, thus avoiding having to interact and/or connect physical qubits in non-trivial ways, here non-nearest neighbour geometries.

In some embodiments there are four or more surface code patches as logical qubits, in particular K $\times$ L surface code patches, arranged in a rectangular array. In some of these embodiments, there are data bus patches of qubits, preferably chains of qubits, connecting all surface code patches in one row, preferably in all rows of the rectangular array. Alternatively or additionally, in some embodiments there are data bus patches, preferably chains, connecting all surface code patches in one column, preferably in all columns of the rectangular array.

In preferred embodiments, the quantum computing device of the invention consists of a rectangular array of (K(d+w+1) - w) $\times$ (L(d+w+1) - w) physical qubits containing K $\times$ L logical qubits encoded by square surface code patches with distance d and thus each containing (d+1) $\times$ (d+1) qubits, separated from each other by rectangular patches of qubits serving as data busses of width m, where there are K-1 horizontal data bus patches of (L(d+w+1)-w) $\times$ w qubits each and L-1 vertical data bus patches of (K(d+w+1)-w) $\times$ w qubits each.

In another aspect of the invention, a method for performing a merge operation during lattice surgery based quantum computing according to claim 9 is disclosed.

Given a first and second logical qubit, each in the form of a surface code patch with distance $d$, in a first step a rectangular patch of $N \times w$ physical qubits are prepared in a GHZ state, the set of $N \times w$ qubits being adjacent to both surface code patches. During a following second step, transversal CNOT operations are performed between the qubits of pairs of adjacent qubits where one member of each pair belongs to the first or second square patch and the other to the set of $N \times w$ qubits. During a following third step, all $N \times w$ qubits are measured in the x-basis. In a fourth step, steps one through three are repeated $h$ times, where h is an integer between 1 and $d$. In a fifth and last step, an error-corrected measurement result is obtained by taking a majority vote over the individual measurement results of step four.

In order to achieve fault tolerance, steps one through five are re-pated a number of times $r$, with $r>=1$, where k=1 means the steps are performed only once.

The number chosen for the parameters $w$, $h$ and $r$ is determined by the desired level $k$ of fault tolerance as well as the depth $d$ of the topological surface code used to encode the quantum information in the logical qubits.

In some embodiments, the level of desired fault tolerance $k$, $k$ being a natural number, is chosen to be equal to the maximum level of fault tolerance for the logical qubits implemented as square planar code patches of distance d, i.e. $k = k_{max} = d$-2 Div 2. In these embodiments, in order to achieve the desired goal of full fault tolerance, the parameters w, h, and r need to satisfy the relationship $w \times h \times r \geq d^2$.

In other embodiments, where $k$ is chosen smaller than $k_{max}$, those thre parameters must still satisfy $w \times h \times r > 4k^2$. For instance, in some embodiments, $k$ may be chosen equal to $d$-4 Div 2. In these embodiments it holds for $w$, $h$ and rthat $\times h \times r > (d - 4)^2$.

In some embodiments of the method of the invention, $r$ is larger than one, i.e. $k > 1$. In some embodiments $k$ is chosen between $d/2$ and d. In some embodiments the number of repetitions is greater or equal to the surface code depth $d$, i.e. $k>=d$.

However, in some embodiments the width of the data bus is chosen to be w>= 3, the the minimum width of 3 being required to ensure that physical connectivity of physical qubits in the hardware still satisfy the constraints of a nearest neighbour geometry. For a width < 3, qubits would need to be interacted/connected in geometrically non-trivial ways and consequently not able to be constructed.

In other embodiments, the set of $N \times w$ qubits is arranged as a physical chain of adjacent qubits, i.e. the width w is chosen equal to one.

In some embodiments, the GHZ state is corrected against bit-flip errors, preferably by performing d cycles of error correction comprising syndrome extraction.

In some embodiments, the fourth step involves at least $d$ repetitions, preferably exactly $d$ repetitions.

In some embodiments of the quantum computing device or the quantum computing method according to this invention the distance $d$ of the surface code is $d$=2. This allows only the detection of a single (either phase or bit-flip) error. In other embodiments the distance d is larger than 2, in particular, 3, 4, 5, 10, 20, 30 or 40. A distance of three is the smallest that allows to correct a (single) error.

The basic idea underlying the invention is to achieve the object of reducing the space overhead for the ancillas needed to provide all-to-all connectivity between qubits by introducing a small data-bus between the planar code patches encoding a logical qubit.

This is done using rectangular patches of $N \times w$ physical qubits, as a data bus, with $w < d$. The qubits in the patches are prepared in a certain error-corrected joint quantum state. For instance, in some embodiments chains, i.e. rectangular patches with $w = 1$, of physical qubits may be used as data bus connecting the patches of logical qubits. To perform a parity check between logical qubits connected by such a chain, the $N$ qubits of the chain may be prepared in a GHZ state.

The data bus of this invention is thus a single long-range stabilizer that acts on logical qubit states. Unlike surface-code stabilizers which are regularly measured during syndrome extraction, this logical stabilizer is only enforced once when logical information has to be manipulated, i.e. when lattice surgery merge or split operations have to be performed. Similarly to stabilizers it does only encode a single classical bit of information. This classical bit of information does not require the full error correction that a logical qubit needs. Instead, it can be encoded using simpler error correction methods such as the repetition code. This approach is completely consistent with the surface code and can be implemented on any architecture that supports the surface code.

The use of a rectangular patch of qubits as data bus between surface code patches has several advantages over the use of square ancilla patches. Mainly, it allows arbitrary connectivity of different surface code patches without any movement and the overhead in terms of ancilla qubits is reduced. Additionally, Y -state measurements and parity checks are supported without any additional overhead during the computation. In the non-rotated layout of the planar code the qubits that are required during merge operations can be used to make up the data bus. The reduction in ancilla qubits does not come at the cost of adding additional qubits in this case. Rotated patches are supported by the data bus as well. However, a single layer of physical qubits is needed between neighboring patches.

This data bus architecture is also beneficial for communication between different quantum computers. It allows interfaces between different fault-tolerant architectures. Lattice surgery between various codes has recently been shown to be possible by Nautrup et al and their methods can be extended to arbitrary connectivity using the data bus of this invention.

However, there is still a trade-off to be made: While the scheme underlying the invention reduces the overhead for all ancilla patches and thus physical qubits, the time to execute a multi-qubit measurement takes longer depending on the distance of the surface code. This trade-off seems to be beneficial in most of the cases, especially for early fault-tolerant computations where algorithms are unlikely to be deep and the distances are short.

Due to the longer time taken for a computation, more error correction is required for a given coherence time of the qubits and desired confidence in the result, partially cancelling the gains achieved by the invention. Each preparation of the data bus requires d rounds of stabilizer measurements. The whole procedure needs to be repeated for d times resulting in a total time overhead of $d^2$. A merge operation only requires d rounds of error correction. With the inclusion of this time overhead the distance needs to be adjusted. We found that for executing distillation protocols the data bus of the invention is still beneficial in terms of total qubits for distances up to $d = 40$. Even better performance can be expected for hybrid models, where nearest neighbor merges are performed traditionally and the data bus is used for the rest.

All commercially viable quantum algorithms have to be fault-tolerant. Fault-tolerance comes at a resource cost: This cost takes the form of overhead in both time and qubit count. In order to perform error corrected, fault tolerant quantum machines, the quantum industry requires several orders of magnitude in additional qubits than what exists on quantum cloud platforms today.

The scalability of Noisy Intermediate Scale Quantum (NISQ) computers poses great challenges for fault-tolerant computations. These technological barriers require significantly reducing the qubit count that is required for error correction, while maintaining computational fault-tolerance.

The ratio of physical qubits to logical qubits is roughly 1000:1. This redundancy of physical qubits is required for logical computation to run algorithms on every known architecture. Topological surface codes have not been demonstrated for more than one logical qubit.

The data bus reduces the number of qubits necessary for error correction by three orders of magnitude by eliminating resource hungry ancillary regions of the encoded computer. This is of practical interest for those interested in running quantum chemistry algorithms. The data bus transforms all layers of the quantum computing stack (e.g. as envisioned by Google, IBM, Intel, Microsoft, Riggeti) from the high-level quantum algorithm to the lowest level's chip designs. It can be applied to any hardware and is independent of platform.

The data bus improves resource counts in two critical areas of quantum computing development:

    1) Interaction of two surface code patches on NISQ machines.

    2) Large-scale circuits with a structure similar to state-of-the-art quantum chemistry circuits.

The principle disclosed in the embodiments of the invention may be extended to arbitrary multi-qubit operations without departing from the scope of the invention.

Further details and features of embodiments of the present invention are described below with reference to the figures.

BRIEF DESCRIPTION OF THE DRAWINGS

| | |
|---|---|
| Figure 1: | An exemplary embodiment of the quantum computing device of the invention comprising a $3 \times 3$ array of surface code patches connected by two horizontal and two vertical data bus patches of qubits |
| Figure 2A: | An illustration of an XX-parity check implementing a merge operation in an embodiment of the invention employing surface code patches with a distance of d=2 |
| Figure 2B: | An example of a stabilizer table for the embodiment illustrated in Figure 2A |
| Figure 3: | A circuit for preparing a set of data bus qubits of a quantum computing device according to embodiments of the invention in a GHZ state usable in a parity check measurement |
| Figure 4: | An illustration of the temporal evolution of a known device and computation method, wherein two-qubit operations between logical qubits are performed using a data bus with a width corresponding to the edge length of the square surface code patches corresponding to the logical qubits and fault tolerance is achieved by d-cycles of error correction. |
| Figure 5A: | An illustration similar to the one shown in Fig. 4, yet with fewer cycles of error correction leading to a loss of fault tolerance. |
| Figure 5B: | An illustration of how, in the method of Fig. 5A, temporal chains of local errors do not affect Z logical operators, even at fewer cycles of error correction. |
| Figure 5C: | An illustration how, in the method of Fig. 5A, temporal chains of local errors negatively affect X logical operators. |

Figure 6:     An illustration of the temporal evolution of a single two qubit operation according to the method of the invention, wherein two-qubit operations between logical qubits are performed using a data bus with a width that is smaller than the edge length of the square surface code patches corresponding to the logical qubits.

Figure 7:     An illustration of the temporal evolution of the fully fault tolerant two qubit operation according to the method of the invention, wherein the two-qubit operation of Fig. 6 is repeated multiple times.

## DETAILED DESCRIPTION OF ILLUSTRATIVE EMBODIMENTS

In the following, illustrative embodiments of the device and the method for performing quantum computing according to this invention are presented.

In the figures, the same reference numerals are used also for different embodiments to denote features of corresponding function or meaning.

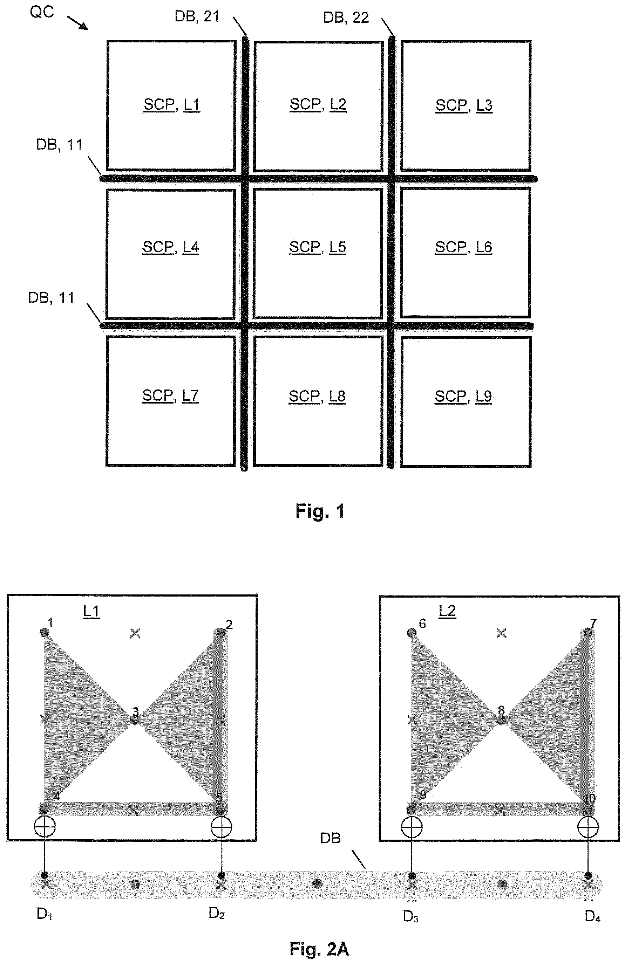

An embodiment of the quantum computing device according to the invention is shown in Figure 1. The hollow squares SCP represent surface code patches encoding logical qubits 101 - 109 and the black lines DB between represent rectangular patches of qubits making up the data bus connecting the square surface code patches and thus enabling two-qubit operations between the logical qubits.

This allows effective all-to-all connectivity between the logical qubits 101 - 109 where logical operators are stored on patches of planar code surrounded by a single string of repetition code.

The grid between different surface code patches making up the data bus can have a thickness of only a single qubit. This is in stark contrast to the thickness of ancilla patches of the state of the art, where the thickness is given by the distance d of the surface code. Thus in contrast to the state of the art, the quantum computing device of the invention advantageously reduces the overhead of physical qubits required. Contrasting a lattice, where the thickness of the data bus patches equals d, to one where the thickness is only a single qubit, the reduction in the number of physical qubits approaches 75 % in the limit of large d. However, this does not take into account the fact that the quantum computing device of the present invention has more stringent error correction requirements due to the time overhead incurred by moving to a data bus with widths less than d. This necessitates moving to surface codes with larger distances d for a given desired level of confidence, i.e. likelihood of error in the final result. However, even taking this partial offset into account, there remains a net benefit. That is to say, while the time penalty associated with using the data bus requires a larger d than if it is not used and a larger d means that all logical qubits in the computer actually require more physical qubits as the size of a logical qubit when using the data bus (in terms of physical qubits) is larger, because all the physical qubits needed for ancillary patches are eliminated when using the data bus, there is still an overall savings in physical qubits for the entire computer.

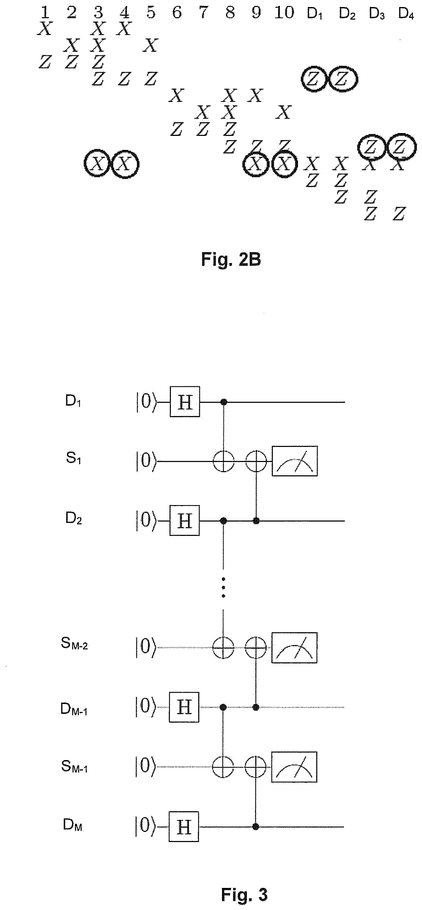

An embodiment of the method for performing a parity check between two logical qubits connected by a rectangular patch of qubits serving as a data bus is now presented with reference to **Figures 2A** and **2B.**

Figure 2A shows two surface code patches L1, L2 of distance d=2, i.e. with 9 qubits each. The triangular areas represent stabilizers. X-stabilizers are illustrated by horizontal, Z-stabilizers by vertical hatching. Data qubits 1 - 10 of the planar code patches are given by dots and syndrome qubits are given by crosses. Logical X and logical Z operators are represented by the horizontal and vertical bars respectively. A data bus DB of N = 7 qubits in a chain, the four data qubits $D_1 - D_4$ separated from each other by three syndrome qubits, connects the two square surface code patches. For the data bus qubits, the meaning of syndrome and data qubits is flipped compared to the logical qubits, i.e. crosses are the data qubits $D_1 - D_4$ and dots the syndrome qubits of the data bus DB.

The sequence of steps to perform an error corrected XX-parity measurement implementing a merge operation is as follows:

> 1) Prepare the N=7 qubits of the data bus DB in a GHZ state, e.g. by using the circuit of Fig. 3, and preferably including a d-cycles of error correction;
> 2) Perform transversal CNOT operations between adjacent, i.e. nearest neighbor data qubits $D_1 - D_4$ of the data bus DB and the two surface code patches. As illustrated in Fig. 2A, the control qubits of these CNOTs are the data qubits $D_1 - D_4$ of the data bus DB, while the targets are the data qubits (4, 5, 9 ,10) of the code patches. These CNOT operations are preferably performed simultaneously;
> 3) Without measuring any further stabilizers, measure all data qubits $D_1 - D_4$ of the data bus DB, i.e. all data bus qubits represented by an 'X" in Fig. 2A, in the x-basis
> 4) Repeat steps 1 - 3 d-times
> 5) Apply a majority vote to the measurement results of step d to obtain the error corrected measurement result of the XX-parity measurement.-

In the example, a distance of d=2 is shown, but arbitrary distances can be used. The value d=2 allows the smallest implementations in terms of number of qubits, but like all other even distances, there is the downside that a split vote may occur in step 5. The fact that the vote may be split for d = 2 and potentially for d = 4, 6, 8 etc... reflects the fact that for even distance the surface code is not a deterministic corrector of (d-1)/2 errors. For odd d we should always be able to detect and correct (d-1)/2 errors. There is always a clear majority vote for odd d.

For the original layout of two neighboring logical qubits in a square array, between which a merge-operation is to be performed, as illustrated in Fig. 2A, without the data bus, the total qubit count is 77. By using the data bus the qubit count is reduced to the 28 qubits shown in Fig. 2A.

This is sufficient for implementation on new qubit chipsets. For large-scale computation, the routing often comprises one third of the number of qubits for a circuit. For large volumes, numerical evidence points to an apparent net benefit of the application of a data bus on the order of 15% or more.

The procedure is now described in more detail. In the first step an N-qubit GHZ-state has been prepared and its errors have been corrected. In the example in Fig. 2A, N=4 corresponding to the four data qubits of the data bus. For general N, we can assume that the state is given by:

$$|\psi\rangle = |00\ldots0\rangle + 11\ldots1\rangle$$

This state can be expressed in the x-basis:

$$|\psi\rangle = \frac{1}{\sqrt{N}} \sum_{\substack{s\in\{+,-\}^N, \\ \textit{even no. of-in } s}} |s\rangle$$

This means that the total parity of the GHZ-state is even in the x-basis. It also means that the total parity of this repetition code does not change under the application of any even number of physical Z-operations on the data qubits.

Fig. 2A shows how individual patches of logical qubits are connected to this data bus that supports Z-parity checks. The CNOTs are applied on a chain of qubits that correspond to the logical X-operator of the individual surface code patches which neighbors the data bus. Each of the patches will add an odd number of Z operations to the GHZ-state if they are in the |-> state and thus flip the total parity (to flip the state from |+> to |-> a logical Z operation needs to be applied). If a data qubit of one of the surface code patches is in the |+> state the total parity will not be changed. During the third step of the procedure according to this embodiment, a measurement in the x-basis of each individual qubit of the GHZ-state will result in the total parity of all logical qubits. The exact operation can also be seen on an example of a stabilizer table shown in Fig. 2B, where the changes due to the CNOTs are highlighted by circles.

The row with the four circled X operators is particularly interesting because this is a product of the total parity of the GHZ-state in X-basis with the XX parity of both patches. The total parity of this stabilizer is even.

Therefore, one is able to deduce the logical XX measurement by a measurement of the parity of the GHZ-state.

Fig. 2A illustrates an XX-parity check. However, for a ZZ-parity check the same general procedure can be performed with the exception of the GHZ-state being initialized in the x-basis instead of the z-basis: $|\psi\rangle=|++\ldots+\rangle+ 1--\ldots->$, the CNOTs needing to connect this x-basis GHZ-state with the logical Z-operator chain, the CNOTs being inverted (target qubits of the CNOTs are the data qubits of the bus) and the final measurement needs to be in the Z-basis for the ZZ-parity check.

The strength of the error correction of this scheme is now derived from the example of the XX parity-check presented before and illustrated in Figures 2A and 2B.

The main ingredient is the error corrected N-qubit GHZ-state. The circuit in Figure 3 creates the GHZ-state along a line of qubits where each second qubit is a syndrome qubit that can detect a change in ZZ-parity of its neighbors. Each stabilizer measurement is repeated d times to correct for measurement errors. After the GHZ-state has been created and verified, a transversal CNOT between the surface-code patches and the GHZ-state can be performed. Immediately afterwards, the data qubits of the GHZ-state are measured.

The measurement will collapse the state into one of two sub-spaces. One subspace has an even number of Pauli-X errors. The protected quantity of interest is the total parity along the data bus. An even number of errors does not influence the total result. The probability of this happening is given by

$$P_{even} = N \sum_{i=0}^{\infty} p_{phys}^{2i}$$

where N is a normalization factor to ensure that the probabilities of all odd and even outcomes sum to 1.

The other sub-space has an odd number of errors and results in the wrong logical result. The probability for such an event is given by:

$$P_{odd} = N \sum_{i=0}^{\infty} p_{phys}^{2i+1} = p_{phys} P_{even}$$

The odd subspace which results in a wrong measurement is less likely by a factor of $p_{phys}$ and repeated measurements can be performed for better protection against errors. For an N-qubit GHZ-state N measurements are needed. The majority of the measurement results will give the error-protected result of the parity between the two patches.

**Figure 3** is an illustration of a circuit which may be used to prepare the data qubits of the rectangular data bus qubit patch connecting two surface code patches of a quantum computing device according to the invention in a GHZ state.

The qubits $D_1$, $D_2$, $D_{M-1}$ and $D_M$ are the data qubits, which alternate with the syndrome qubits $s_1$, $s_{M-2}$

and $s_{M-1}$. Here the number N of qubits in the data bus qubit patch is given by N=2M+1. The left-right axis represents time with operations performed at a later time lying to the right. The ellipsis signifies that in the complete circuit the elements shown are repeated in the same fashion. As shown all qubits are initialized in the state |0>. Then a Hada-mard gate H is performed on the data qubits, changing each of their single qubit states to |+> + |-> (without normalization). Then each syndrome qubit k is the target of two CNOT controlled by its respective neighboring data qubits k and k+1. Shown in Fig. 3 are two CNOTs controlled by data qubits 1 and 2 acting on syndrome qubits $S_1$, two CNOTs controlled by data qubits M-2 and M-1 acting on syndrome qubits $S_{M-2}$ and two CNOTs controlled by data qubits M-1 and M acting on syndrome qubits $S_{M-1}$. The syndrome qubits are then measured repeatedly d times where d is the distance of the surface code patches that are to be connected by the data bus.

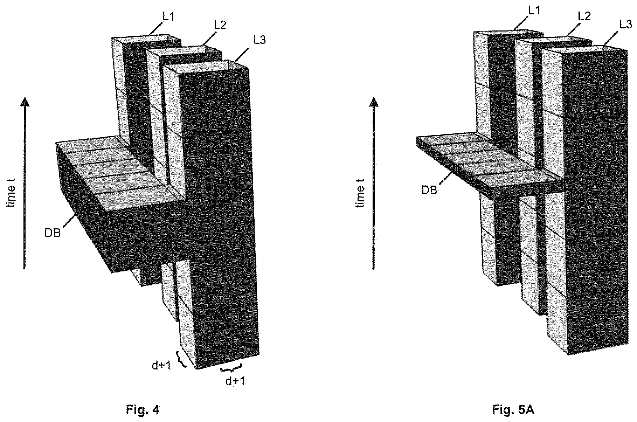

In the **Figures 4-7** the temporal evolution of known lattice surgery implementations and embodiments of the invention are comparatively illustrated.

**Fig. 4** depicts an illustration of the temporal evolution of a known device an computation method, wherein two-qubit operations between logical qubits are performed using a data bus with a width corresponding to the edge length of the square surface code patches corresponding to the logical qubits and fault tolerance is achieved by d-cycles of error correction.

Shown is the temporal evolution of three logical qubits L1, L2 and L3 each consisting of a square patch of $(d+1)\times(d+1)$ physical qubit in a joint quantum state corresponding to a planar surface code and each encoding one logical qubit of (quantum) information. The rectangular patch represents a region of physical qubits that encode bus information. The time axis t extends in the direction of the arrow and the two horizontal axis perpendicular to it are the spatial extent of the device.

At some point in time a two qubit interaction between qubits L1 and L3 is initiated by setting up a data bus DB made up of ancilla qubits. The data bus requires a large number of physical qubits, as its length needs to be sufficient to connect logical qubits L1 and L3 via their full edge facing the data bus and past qubit L2 and, more importantly its width according to the lattice surgery techniques known in the art, corresponds to the width of the qubits it connects, i.e. is equal to $d+1$.

In the temporal direction the data bus DB, in order to correct of any localized errors occuring in its physical ancilla qubits during the time it exists, extends for d+1 time steps as well, i.e. it requires d-cycles of error correction to correct for such errors.

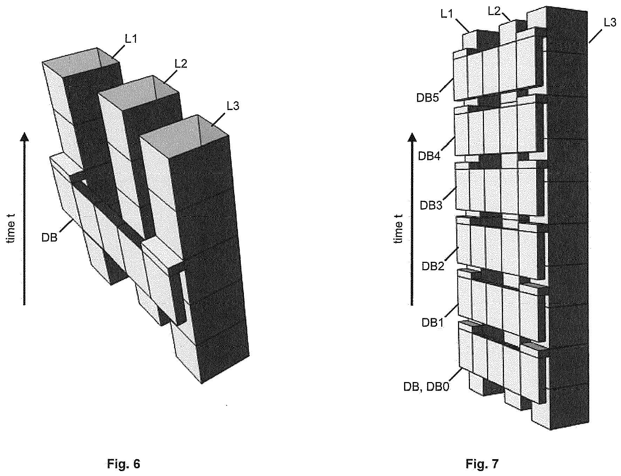

In **Fig. 5A,** according to the some embodiments of the invention, the number of error correction cycles performed during engagement of the data bus DB is reduced from $d$ to a smaller number $h<d$, while the width remains $w = d$ (or $d+1$ if counting qubits) thereby speeding up the two-qubit operation implemented through the interaction between qubits L1 and L3 mediated via the data bus DB while giving up full fault protections against errors. There is a trade-off between the number of error correction cycles and consequent the level of protection against errors and the achieved speedup. Full fault tolerance may be regained by repeating the data bus in the same way as it is illustrated in Fig. 7 for embodiments with a data bus width $w < d$.

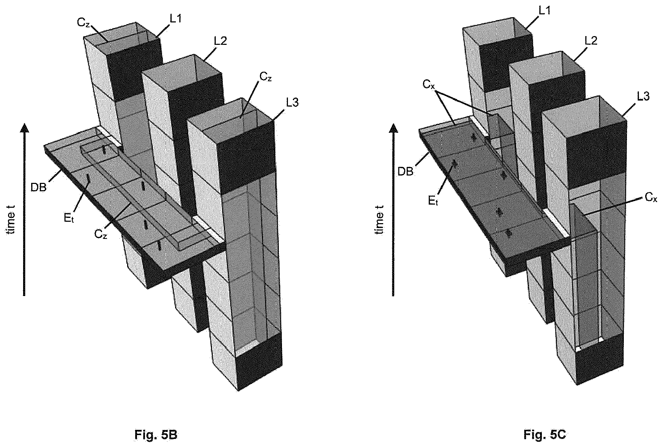

In **Figures 5B** and **5C** the effects of localized errors on the data bus DB is illustrated. In the temporal evolution shown here, uncorrected localized errors occuring in the logical ancilla qubits used for the data bus DB form short temporal error chains Et. In the implementation where d cycles of error correction are performed, as depicted in Fig. 4, these errors would have been corrected, but due to the reduction in numbers of error correction cycles to h < w, these errors are uncorrectable and the error chains Et remain.

The temporal evolution of the encoded information is tracked using correlation surfaces or sheets. Fig. 5B shows a correlation surface Cz that connects the z logical operator of logical qubit L1 with that of logical qubit L3, while Fig. 5C similarly shows a correlation surface Cx connecting the logical x-operators of the qubits L1 and L3 connected by the data bus DB. As can be seen in the figures, since the z-correlation sheets Cz extend only in temporal direction, the one belonging to the data bus DB is not pierced by the error chains Et. Hence there is no interaction between uncorrelated errors and the correlation surface that dictates the information content as it evolves in time. Therefore these errors will not damage the encoded information.

This is in contrast to the situation shown in Fig. 5C. As can be seen there, the x-operator correlation surface Cx, which is a second correlation surface that is directly measured during the coupling operation mediated by the data bus DB, extends in spacial direction, while being temporally localized, i.e. instantaneous. These sheets represent a direct two-qubit parity check of the encoded information.

Due to the orientation of the correlation surfaces Cx, the small uncorrected and, given the reduced number of error correction cycles, uncorrectable error chains Et now pierce the surfaces Cx belonging to the data bus DB. This causes an error in the multi-qubit measurement that if left unchecked, could corrupt the computation. In the art, there is no known solution to this problem.

However, it is the surprising insight of present invention that unlike the case of a z operator error, the piercing of x operator correlation sheets Cx is not affecting any stored information in each logical qubit, but instead represents an error associated with a new parity measurement over the joint two qubit system formed by the logical qubits L1 and L3. This can be corrected by measuring the same operator multiple times.

This leads to the implementation of instant invention depicted in **Figures 6** and **7.** Here the bus region DB is folded into the temporal direction of the system evolution without changing its fundamental operation. This reduces the cross sectional size of the geometric description which in term reduces the number of physical qubits needed to implement the coupling operation mediated through the data bus DB. I.e., by performing the full d cycles of error correction, it is possible to reduce the number of physical qubits used as ancilla in the data bus DB by reducing its width from the value $d+1$ used in the prior art to a value less than that, as is illustrated in Fig 6. In particular, in the extreme case, the width may be reduced to a single qubit.

The embodiment of Fig. 6 employing a single interaction between the qubits L1 and L3 mediated via one data bus DB shows this fundamental advantage of present invention, namely the reduction in ancilla qubits required. However, it leaves errors in tthe joint parity measurement occuring in the data bus DB uncorrected.

The preferred embodiment shown in Fig. 7 suppresses these joint parity measurement errors by doing the operation many times using multiple implementations DB0, DB1, ..., DB4 of the data bus. The amount of redundancy needed to ensure accurate parity measurements and consequently full fault tolerance is determined by the number of times the operation, i.e. the interaction via a data bus, is repeated. In the figure there are four repetitions shown, yet this is purely for illustrative purposes. The exact number needed depends on the level of suppression desired as well as the depth d of the surface code used.

The great advantage of this embodiment is that this repeated measurement does not require any more physical qubits compared to measuring it only once and maintains full fault-tolerance of the data bus mediated two-qubit interaction.

**List of reference characters**

| QC | quantum computing device |
| DB | data bus |
| DB1-4 | data bus repetitions |
| SCP | surface code patch encoding a logical qubit |
| L1 - L9 | logical qubits |
| 1-10 | data qubits of the surface code patches |
| $D_1$ - $D_M$ | data qubits of the data bus |
| $S_1$ - $S_{M-1}$ | syndrome qubits of the data bus |
| t | time axis |
| Cz | Z-operator correlation surface |
| $C_X$ | X-operator correlation surface |
| $E_t$ | temporal error chain |

**Claims**

1. A quantum computing device for performing fault-tolerant topological quantum computation comprising

- a plurality of logical qubits (L1, ..., L9) each corresponding to a square patch of $(d+1) \times (d+1)$ physical qubits in a joint quantum state corresponding to a surface code, the qubits of each square patch being classified as either data qubits or syndrome qubits and the surface code having a distance d of two or more,
- one or more rectangular patches of $N \times w$ physical qubits in a joint quantum state serving as a data bus (DB) with a length $N>=2$ and a width w,
- wherein, in order to be able to perform a multi-qubit operation between two or more logical qubits (L1, L2, L3) of the plurality of logical qubits (L1, ..., L9), the data bus (DB) connects two or more of the logical qubits in the sense that each of the two or more square patches corresponding to the two or more logical qubits contains a physical qubit that is adjacent to a physical qubit of the data bus, wherein two physical qubits are called adjacent if there are means for performing two-qubit CNOT operations between them,
- wherein the device is configured to

  o perform the multi-qubit operation fault-tolerantly up to an error level k, k being a natural number smaller or equal to d-2 Div 2 by completing h cycles of error correction with h being smaller or equal to d, before the data bus (DB) is disconnected, and
  o repeat the multi-qubit operation between the logical qubits mediated by the data bus (DB) r-times, r being a natural number where r = 1 means the data bus is established only once, and

wherein the device is further configured to

- speed up the multi-qubit operation by reducing the number h of error correction cycles performed during engagement of the data bus (DB) from d to a smaller value $h<d$, while the width remains $w=d$, or reduce the number of physical qubits required to perform the multi-qubit operation by folding the data bus (DB) into the temporal region by performing the full $h=d$ cycles of error correction, but reducing the width w of the data bus (DB) to a value smaller than d, and
- always choose the number of repetitions r of the multi-qubit operation according to the desired level of fault tolerance k such that the space-time volume $V_{DB}$ of the data bus (DB) including all of its repetitions given by $V_{DB} = w \times h \times r$ satisfies $V_{DB} > 4 k^2$, whereby, if $r = 1$, then w or h are smaller than d, and, if $w = 1$, then h or r are smaller than d.

**2.** The device according to Claim 1, **characterized in that** the level k of fault tolerance is chosen to be $k = (d-2)$ Div 2 and space-time volume of the data bus satisfies $V_{DB} >= d^2$.

**3.** The device according to Claims 1 or 2, **characterized in that** the number of times r the multi-qubit operation is repeated satisfies r = 2 or d > r > d/2.

**4.** The device according to Claim 1 or 2 **characterized by** the distance d of the surface code being greater than two.

**5.** The device according to one of the preceding Claims, **characterized in that** the width w of the data bus is w=1.

**6.** The device according to one of the Claims 1 - 4, **characterized in that** the width w of the data bus (DB) is greater or equal to three.

**7.** The device according to one of the preceding Claims, wherein the length N of the data bus is greater or equal to the sum of the side lengths of the square qubit patches encoding the logical qubits, i.e. $N>=2(d+1)$.

**8.** The device according to one of the preceding Claims, wherein the $N \times w$ qubits of the data bus are in a joint GHZ state.

**9.** A method for implementing a Merge operation by performing an arbitrary length fault tolerant parity check between a first and a second logical qubit in a surface code quantum computing device according to the previous claims, comprising

a) preparing the first logical qubit (L1) and the second logical qubit (L2, L3) each in the form of square patch of $(d+1) \times (d+1)$ physical qubits in a joint quantum state corresponding to a surface code with distance d, the qubits of the square patches being classified as either data qubits or syndrome qubits,
b) preparing a square patch of $N \times w$ physical qubits with $N >= 2$ and $w>=1$ in a joint GHZ-state as a data bus (DB), wherein the data bus connects the first and second logical qubits in the sense that each of the logical qubits (L1, L2, L3) contains one or more data qubits that are adjacent to a qubit of the data bus (DB),
c) for each data qubit of the first logical qubit (L1) and second logical qubit (L2, L3) adjacent to a qubit of the data bus (DB), performing a transversal CNOT operation between that data qubit and the qubit of the data bus to which it is adjacent,
d) measuring all qubits of the data bus (DB),

e) repeating steps b) - d) h times,
f) obtaining an error corrected measurement result by a majority vote over the individual measurement results of step d), and
g) repeating the steps a)-f) r-times with r being a natural number,

wherein the Merge operation is

- sped up by reducing the number h of error correction cycles performed during engagement of the data bus (DB) from d to a smaller value h<d, while the width remains w=d, or
- performed with a reduced number of physical qubits by folding the data bus (DB) into the temporal region by performing the full h=d cycles of error correction, but reducing the width w of the data bus (DB) to a value smaller than d,

while the number of repetitions r of the Merge operation is chosen such that the space-time volume $V_{DB}$ of the data bus (DB) including all its repetitions given by $V_{DB} = w \times h \times r$ satisfies $V_{DB} > 4 k^2$, whereby the desired error level k is a natural number smaller or equal to d-2 Div 2 and whereby if r =1, then w or h are smaller than d, and if w = 1, then h or r are smaller than d.

**10.** The method according to Claim 9, **characterized in that**, during step b, the qubits of the data bus (DB) are kept protected against bit flip errors.

**11.** The method according to Claims 9 or 10, **characterized in that** the width w of the data bus is chosen to be greater of equal to three, in particular equal to three.

**12.** The method according to one of the Claims 9 - 11, **characterized in that**, in step c, at least two CNOT operations are performed simultaneously.

**13.** The method according to Claim 14, **characterized in that**, in step c, all CNOT operations are performed simultaneously.

**14.** The method according to one of the Claims 9 - 13, **characterized in that** the number of repetitions r is greater or equal than d/2.

**Patentansprüche**

**1.** Ein Quantencomputergerät zur Durchführung einer fehlertoleranten topologischen Quantenberechnung, umfassend

- eine Vielzahl logischer Qubits (L1, ..., L9), die jeweils einem quadratischen Feld von $(d+1) \times$

(*d*+1) physikalischer Qubits in einem zu einem Oberflächencode korrespondierenden gemeinsamen Quantenzustand entsprechen, wobei die Qubits jedes quadratischen Feldes entweder als Daten-Qubits oder als Syndrom-Qubits klassifiziert sind und der Oberflächencode einen Abstand *d* von zwei oder mehr hat,

- ein oder mehrere rechteckige Felder von $N \times w$ physikalischen Qubits in einem gemeinsamen Quantenzustand, die als Datenbus (DB) einer Länge *N*>=2 und einer Breite w dienen,

- wobei, um eine Multi-Qubit-Operation zwischen zwei oder mehreren logischen Qubits (L1, L2, L3) der Mehrzahl logischer Qubits (L1, ..., L9) durchführen zu können, der Datenbus (DB) zwei oder mehr der logischen Qubits in dem Sinne verbindet, dass jedes der zwei oder mehr quadratischen Felder, die den zwei oder mehr logischen Qubits entsprechen, ein physikalisches Qubit enthält, das an ein physikalisches Qubit des Datenbusses angrenzt, wobei zwei physikalische Qubits angrenzend genannt werden, wenn zwischen ihnen Mittel zur Durchführung von Zwei-Qubit-CNOT-Operationen vorhanden sind,

- wobei das Gerät dazu konfiguriert ist

 o eine Multi-Qubit-Operation bis zu einem Fehlerniveau k fehlertolerant auszuführen, wobei k eine natürliche Zahl kleiner oder gleich *d*-2 Div 2 ist, indem *h* Zyklen der Fehlerkorrektur abgeschlossen werden, wobei h kleiner oder gleich d ist, bevor der Datenbus (DB) abgetrennt wird, und
 o die Multi-Qubit-Operation zwischen den durch den Datenbus (DB) vermittelten logischen Qubits r-mal zu wiederholen, wobei *r* eine natürliche Zahl ist, und *r* = 1 bedeutet, dass der Datenbus nur einmal eingerichtet wird, und

wobei die Vorrichtung weiterhin dazu konfiguriert ist

- die Multi-Qubit-Operation zu beschleunigen, indem sie die Anzahl *h* der Fehlerkorrekturzyklen, die während der Einbindung des Datenbusses (DB) durchgeführt werden, von *d* auf einen kleineren Wert *h* < *d* reduziert, während die Breite *w* = *d* bleibt, oder die zur Durchführung der Multi-Qubit-Operation erforderliche Anzahl an physikalischen Qubits zu reduzieren, indem der Datenbus (DB) in den zeitlichen Bereich gefaltet wird, indem die vollständigen *h* = *d* Zyklen der Fehlerkorrektur durchgeführt werden, aber die Breite *w* des Datenbusses (DB) auf einen kleineren Wert als *d* reduziert wird, und
- dabei immer die Anzahl der Wiederholungen *r* der Multi-Qubit-Operation entsprechend dem gewünschten Grad an Fehlertoleranz *k* zu wählen, sodass das Raum-Zeit-Volumen $V_{DB}$ des Datenbusses (DB) einschließlich aller seiner Wiederholungen, gegeben durch $V_{DB} = w \times h \times r$, $V_{DB} > 4\,k^2$ erfüllt, wobei, wenn *r* = 1, *w* oder *h* kleiner als *d* sind und wenn *w* = 1, *h* oder *r* kleiner als d sind.

2. Die Vorrichtung nach Anspruch 1, **dadurch gekennzeichnet, dass** das Fehlertoleranzniveau *k* zu *k* = (*d*-2) Div 2 gewählt ist und das Raum-Zeit-Volumen des Datenbusses $V_{DB}$ >= d² erfüllt.

3. Die Vorrichtung nach Anspruch 1 oder 2, **dadurch gekennzeichnet, dass** die Anzahl *r* der Wiederholungen der Multi-Qubit-Operation *r* = 2 oder *d* > *r* > *d*/2 erfüllt.

4. Die Vorrichtung nach Anspruch 1 oder 2, **gekennzeichnet durch** einen Abstand *d* des Oberflächenkodes von größer als zwei.

5. Die Vorrichtung nach einem der vorhergehenden Anspüche, **dadurch gekennzeichnet, dass** die Breite w des Datenbusses w=1 ist.

6. Die Vorrichtung nach einem der Anspüche 1 - 4, **dadurch gekennzeichnet, dass** die Breite w des Datenbusses (DB) größer gleich drei ist.

7. Die Vorrichtung nach einem der vorhergehenden Anspüche, wobei die Länge N des Datenbusses größer oder gleich der Summe der Seitenlängen des quadratischen Qubit Feldes ist, welches das logische Qubits kodiert, d.h. *N*>=2(d+1).

8. Die Vorrichtung nach einem der vorhergehenden Anspüche, wobei die $N \times w$ Qubits des Datenbusses in einem gemeinsamen GHZ Zustand sind.

9. Verfahren zum Implementieren einer Merge-Operation durch Durchführen einer fehlertoleranten Paritätsprüfung beliebiger Länge zwischen einem ersten und einem zweiten logischen Qubit in einem Oberflächencode-Quantencomputergerät gemäß den vorherigen Ansprüchen, umfassend

 a) Vorbereiten des ersten logischen Qubits (L1) und des zweiten logischen Qubits (L2, L3), jeweils in Form eines quadratischen Feldes aus (*d*+1) $\times$ (*d*+1) physikalischen Qubits in einem gemeinsamen Quantenzustand, welcher einem Oberflächencode mit Abstand *d* entspricht, wobei die Qubits der quadratischen Felder entweder als Daten-Qubits oder als Syndrom-Qubits klassifiziert werden,
 b) Vorbereiten eines quadratischen Feldes aus $N \times w$ physikalischen Qubits mit $N$ >= 2 und w

>=1 in einem gemeinsamen GHZ-Zustand als Datenbus (DB), wobei der Datenbus das erste und das zweite logische Qubit in dem Sinn verbindet, dass jedes der logischen Qubits (L1, L2, L3) ein oder mehrere Daten-Qubits enthält, die an ein Qubit des Datenbusses (DB) angrenzen,

c) für jedes Daten-Qubit des ersten logischen Qubits (L1) und zweiten logischen Qubits (L2, L3), das an ein Qubit des Datenbusses (DB) angrenzt, Durchführen einer transversalen CNOT-Operation zwischen diesem Daten-Qubit und dem Qubit des Datenbusses, an das es angrenzt,

d) Messung aller Qubits des Datenbusses (DB),

e) Wiederholen der Schritte b) - d) $h$-mal,

f) Erhalten eines fehlerkorrigierten Messergebnisses durch Mehrheitsbeschluss über die einzelnen Messergebnisse von Schritt d), und

g) Wiederholen der Schritte a)-f) $r$-mal, wobei $r$ eine natürliche Zahl ist,

wobei die Merge-Operation

• beschleunigt wird durch eine Reduzierung der Anzahl h der Fehlerkorrekturzyklen, die während des Einschaltens des Datenbusses (DB) durchgeführt werden, von $d$ auf einen kleineren Wert $h<d,$ während die Breite $w = d$ bleibt, oder
• mit einer reduzierten Anzahl physikalischer Qubits durchgeführt wird, indem der Datenbus (DB) in den zeitlichen Bereich gefaltet wird, indem die vollen $h = d$ Zyklen der Fehlerkorrektur durchgeführt werden, aber die Breite $w$ des Datenbusses (DB) auf einen Wert reduziert wird, der kleiner als d ist,

wobei die Anzahl der Wiederholungen $r$ der Merge-Operation so gewählt wird, dass das Raum-Zeit-Volumen $V_{DB}$ des Datenbusses (DB) einschließlich aller seiner Wiederholungen, gegeben durch $V_{DB} = w \times h \times r$, $V_{DB} > 4\ k^2$ erfüllt, wobei das gewünschte Fehlerniveau $k$ eine natürliche Zahl kleiner oder gleich $d$-2 Div 2 ist und, im Falle von $r =1$, $w$ oder $h$ kleiner als $d$ sind, und, im Falle von $w = 1$, dann h oder $r$ kleiner als $d$ sind.

10. Das Verfahren nach Anspruch 9, **dadurch gekennzeichnet, dass** in Schritt b die Qubits des Datenbusses (DB) gegen Bitflip-Fehler geschützt werden.

11. Das Verfahren nach Anspruch 9 oder 10, **dadurch gekennzeichnet, dass** the Breite $w$ des Datenbusses größer oder gleich drei gewählt wird, insbesondere gleich drei.

12. Das Verfahren nach einem der Ansprüche 9 - 11, **dadurch gekennzeichnet, dass** in Schritt c wenigstens zwei CNOT Operationen gleichzeitig durchgeführt werden.

13. Das Verfahren nach Anspruch 14, **dadurch gekennzeichnet, dass** in Schritt c alle CNOT Operations gleichzeitig durchgeführt werden.

14. Das Verfahren nach einem der Ansprüche 9 - 13, **dadurch gekennzeichnet, dass** die Anzahl $r$ der Wiederholungen größer oder gleich $d$/2 ist.

**Revendications**

1. Dispositif informatique quantique pour effectuer un calcul quantique topologique tolérant aux pannes comprenant

- une pluralité de qubits logiques (L1, ..., L9) correspondant chacun à un carré de $(d+1) \times (d+1)$ qubits physiques dans un état quantique conjoint correspondant à un code de surface, les qubits de chacun un patch carré étant classé soit comme qubits de données, soit comme qubits de syndrome et le code de surface ayant une distance d de deux ou plus,
- un ou plusieurs patchs rectangulaires de N × w qubits physiques dans un état quantique conjoint servant de bus de données (DB) de longueur N>=2 et de largeur w,
- dans lequel, afin de pouvoir effectuer une opération multi-qubits entre deux ou plusieurs qubits logiques (L1, L2, L3) de la pluralité de qubits logiques (L1, ..., L9), le bus de données (DB) connecte deux ou plusieurs qubits logiques dans le sens où chacun des deux ou plusieurs carrés correspondant aux deux ou plusieurs qubits logiques contient un qubit physique qui est adjacent à un qubit physique du bus de données, deux qubits physiques étant appelés adjacents s'il existe des moyens pour effectuer des opérations CNOT à deux qubits entre eux,
- dans lequel le dispositif est configuré pour

o effectuer l'opération multi-qubits avec tolérance aux pannes jusqu'à un niveau d'erreur k, k étant un nombre naturel inférieur ou égal à d-2 Div 2 en effectuant h cycles de correction d'erreur avec h étant inférieur ou égal à d, avant le bus de données (DB) est déconnecté, et

o répéter l'opération multi-qubits entre les qubits logiques médiés par le bus de données (DB) r fois, r étant un nombre naturel où r = 1 signifie que le bus de données n'est établi qu'une seule fois, et

dans lequel le dispositif est en outre configuré pour

- accélérer le fonctionnement multi-qubits en réduisant le nombre h de cycles de correction d'erreur effectués lors de l'engagement du bus de données (DB) de d à une valeur h<d plus petite, tandis que la largeur reste w=d, ou réduire le nombre de qubits physiques requis pour effectuer l'opération multi-qubits en repliant le bus de données (DB) dans la région temporelle en effectuant les cycles h=d complets de correction d'erreur, mais en réduisant la largeur w du bus de données (DB) à une valeur plus petite que d, et

- toujours choisir le nombre de répétitions r de l'opération multi-qubits en fonction du niveau de tolérance aux pannes k souhaité tel que le volume spatio-temporel $V_{DB}$ du bus de données (DB) incluant toutes ses répétitions donné par $V_{DB} = w \times h \times r$ satisfait $V_{DB} > 4\,k^2$, où, si r = 1, alors w ou h sont plus petits que d, et, si w = 1, alors h ou r sont plus petits que d.

2. Dispositif selon la revendication 1, **caractérisé en ce que** le niveau k de tolérance aux pannes est choisi $k = (d\text{-}2)$ Div 2 et le volume spatio-temporel du bus de données satisfait $V_{DB} >= d^2$.

3. Dispositif selon les revendications 1 ou 2, **caractérisé en ce que** le nombre de fois r où l'opération multi-qubit est répétée satisfait à r = 2 ou d > r > d/2.

4. Dispositif selon la revendication 1 ou 2 **caractérisé en ce que** la distance d du code surfacique est supérieure à deux.

5. Dispositif selon l'une des revendications précédentes, **caractérisé en ce que** la largeur w du bus de données est w=1.

6. Dispositif selon l'une des revendications 1 à 4, **caractérisé en ce que** la largeur w du bus de données (DB) est supérieure ou égale à trois.

7. Dispositif selon l'une des revendications précédentes, dans lequel la longueur N du bus de données est supérieure ou égale à la somme des longueurs de côté des patchs de qubits carrés codant pour les qubits logiques, soit N > = 2 (d + 1 ).

8. Dispositif selon l'une des revendications précédentes, dans lequel les $N \times w$ qubits du bus de données sont dans un état GHZ commun.

9. Procédé pour mettre en oeuvre une opération de fusion en effectuant un contrôle de parité tolérant aux pannes de longueur arbitraire entre un premier et un deuxième qubit logique dans un dispositif informatique quantique à code de surface selon les revendications précédentes, comprenant

a) préparer le premier qubit logique (L1) et le deuxième qubit logique (L2, L3), chacun sous la forme d'un carré de $(d+1) \times (d+1)$ qubits physiques dans un état quantique conjoint correspondant à un code surfacique de distance d, les qubits des carrés étant classés soit en qubits de données, soit en qubits de syndrome,

b) préparer un carré de $N \times w$ qubits physiques avec N >= 2 et w>=1 dans un état GHZ commun en tant que bus de données (DB), le bus de données connectant le premier et le deuxième qubits logiques dans le sens que chacun des qubits logiques (L1, L2, L3) contient un ou plusieurs qubits de données qui sont adjacents à un qubit du bus de données (DB),

c) pour chaque qubit de données du premier qubit logique (L1) et du deuxième qubit logique (L2, L3) adjacent à un qubit du bus de données (DB), effectuer une opération CNOT transversale entre ce qubit de données et le qubit de le bus de données auquel il est adjacent,

d) mesurer tous les qubits du bus de données (DB),

e) répéter les étapes b) à d) *h* fois,

f) obtenir un résultat de mesure corrigé des erreurs par un vote majoritaire sur les résultats de mesure individuels de l'étape d), et

g) répéter les étapes a) à f) *r* fois, *r* étant un nombre naturel,

dans lequel l'opération de fusion est

• accéléré en réduisant le nombre *h* de cycles de correction d'erreur effectués lors de l'engagement du bus de données (DB) de *d* à une valeur plus petite *h < d,* tandis que la largeur reste *w = d,* ou
• effectué avec un nombre réduit de qubits physiques en repliant le bus de données (DB) dans la région temporelle en effectuant tous les cycles *h = d* de correction d'erreur, mais en réduisant la largeur *w* du bus de données (DB) à une valeur plus petit que *d,*

tandis que le nombre de répétitions r de l'opération de fusion est choisi de telle sorte que le volume spatio-temporel $V_{DB}$ du bus de données (DB), y compris toutes ses répétitions, donné par $V_{DB} = w \times h \times r$, satisfasse $V_{DB} > 4\,k^2$, moyennant quoi le niveau d'erreur souhaité k est un nombre naturel inférieur ou égal à d-2 Div 2 et où si *r* = 1, alors w ou *h* sont plus petits que *d,* et si w = 1, alors *h* ou *r* sont plus petits que *d.*

10. Procédé selon la revendication 9, **caractérisé en ce qu'**à l'étape b, les qubits du bus de données (DB) sont protégés contre les erreurs de retournement de bits.

**11.** Procédé selon la revendication 9 ou 10, **caractérisé en ce que** la largeur w du bus de données est choisie supérieure ou égale à trois, notamment égale à trois.

**12.** Procédé selon l'une des revendications 9 à 11, **caractérisé en ce qu'**à l'étape c au moins deux opérations CNOT sont effectuées simultanément.

**13.** Procédé selon la revendication 14, **caractérisé en ce qu'**à l'étape c toutes les opérations CNOT sont effectuées simultanément.

**14.** Procédé selon l'une des revendications 9 à 13, **caractérisé en ce que** le nombre r de répétitions est supérieur ou égal à d/2.

QC

DB, 21    DB, 22

| SCP, L1 | SCP, L2 | SCP, L3 |
| SCP, L4 | SCP, L5 | SCP, L6 |
| SCP, L7 | SCP, L8 | SCP, L9 |

DB, 11

DB, 11

**Fig. 1**

L1

L2

DB

D₁        D₂        D₃        D₄

**Fig. 2A**

Fig. 2B

Fig. 3

17

Fig. 4

Fig. 5A

Fig. 5B

Fig. 5C

Fig. 6

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **DANIEL HERR.** *Time versus Hardware: Reducing Qubit Counts with a (Surface Code) Data Bus, https://arxiv.org/pdf/1902.08117.pdf*